# EUROPÄISCHE PATENTSCHRIFT

(11) **EP 0 590 644 B1**
(45) Veröffentlichungstag und Bekanntmachung des Hinweises auf die Patenterteilung: **12.06.1996**
(21) Anmeldenummer: 93115737.4
(22) Anmeldetag: 29.09.1993
(51) Int. Cl.: H01R 43/24, B29C 45/14

(54) **Verfahrem zum Umspritzen von elektrischen Kontaktbahnen**
Method for overmoulding of a leadframe
Procédé pour surmoulage de grille de connexion

(30) Priorität: 02.10.1992 DE 4233254
(43) Veröffentlichungstag der Anmeldung: 06.04.1994
(73) Patentinhaber: TRW FAHRZEUGELEKTRIK GmbH & CO. KG, D-78304 Radolfzell (DE)
(72) Erfinder: Schmon, Wilfried, D-88605 Messkirch (DE); Seeh, Erich, D-78579 Neuhausen (DE)
(74) Vertreter: Schieschke, Klaus, Dipl.-Ing.

(56) Entgegenhaltungen:
- EP-A- 0 340 116
- DE-B- 1 048 624
- US-A- 3 521 823
- US-A- 4 956 139
- US-A- 4 965 933
- US-A- 5 038 468

## Beschreibung

Die Erfindung bezieht sich auf ein Verfahren zum Umspritzen von elektrischen Kontaktbahnen, bei welchem mindestens ein zwischen zwei Teile eines Spritzwerkzeuges eingelegtes Metallstanzgitter sowohl durch Trennung und Umbiegen von Verbindungsstegen in die einzelnen Kontaktbahnen aufgeteilt als auch mit Kunststoff umspritzt wird, wobei die Verbindungsstege nach der Fixierung des Metallstanzgitters im Spritzwerkzeug in diesem getrennt und umgebogen und danach die so hergestellten einzelnen Kontaktbahnen mit Kunststoff umspritzt werden.

Nach dem derzeit bekannten Stand der Technik werden vorgefertigte Metallstanzgitter in ein Spritzwerkzeug eingebracht und kunststoffumspritzt. Nach diesem Bearbeitungsvorgang werden die Metallstanzgitter in einem separaten Arbeitsgang in einzelne Bahnen getrennt, indem zwischen den Kontaktbahnen vorhandene Verbindungsstege ausgestanzt oder einseitig geschnitten und gebogen werden. Daraus resultiert ein erheblicher Zeit- und Bearbeitungsaufwand, welcher letztendlich kostensteigernd wirkt. Bedingt durch die Fixierungen und durch den Trennvorgang des Metallstanzgitters entstehen Öffnungen im Kunststoffteil, welche eine mögliche Gestaltung in wasserdichter Form ausschließen.

Aus der US-A-5 038 468 ist ein Verfahren zum Umspritzen von elektrischen Leiterbahnen bekannt, welches zunächst in die Spritzform eingelegt und in dieser vor dem Umspritzen mit Kunststoff getrennt wird. Da die Leiterbahnen nach dem Trennvorgang für das Umspritzen mit Kunststoff fixiert werden müssen, ist die Herstellung eines einseitig dicht umspritzten Teils nicht möglich.

Demgegenüber liegt der vorliegenden Erfindung die Aufgabe zugrunde, ein Verfahren und Vorrichtung der eingangs genannten Art zu schaffen, mit welchem auf kostensparendere Weise kunststoffumspritzte, elektrische Kontaktbahnen enthaltende Fertigteile hergestellt werden können, welche zumindest auf einer Seite der Kontaktbahnen gegenüber Umwelteinflüssen abgedichtet sind.

Diese Aufgabe wird erfindungsgemäß dadurch gelöst, daß vor dem Trennen und Umbiegen der Verbindungsstege ein vorgefertigtes Einlegeteil mit einseitig geschlossener Außenkontur in das Spritzwerkzeug eingelegt und zusammen mit den Kontaktbahnen mit Kunststoff umspritzt wird. Es ergibt sich hierdurch eine erhebliche Reduzierung der Bearbeitungsvorgänge und damit eine Kostenersparnis.

In weiterer Ausgestaltung der Erfindung werden die Verbindungsstege in einem Arbeitsgang einseitig getrennt und umgebogen, so daß eine Reduzierung der Bearbeitungsstufen erzielt wird.

Erfindungsgemäß besteht darüber hinaus die Möglichkeit, daß durch Trenn- und Biegemesser die getrennten Verbindungsstege in geschlossene Taschen des vorgespritzten Einlegeteils hineingedrückt werden, so daß wegen des Einsatzes des Einlegeteils die o.a. Wasserdichtigkeit des Fertigteils gewährleistet ist.

Die Vorrichtung zur Durchführung des Verfahrens ist so gestaltet, daß in einem Teil des Spritzwerkzeuges die auf die Anzahl der Verbindungsstege abgestellten, das Trennen und Umbiegen der Verbindungsstege durchführenden Trenn- und Biegemesser gelagert sind, wobei in dem anderen Teil des Spritzwerkzeuges Aussparungen für die Trenn- und Biegemesser sowie für Fixierstifte vorgesehen sind.

In weiterer Ausgestaltung der Erfindung kann das Einlegeteil einen zumindest einseitig mit einer Profilierung versehenen, umlaufenden Bund zur Einlagerung in den umspritzten Kunststoff aufweisen. Weiterhin kann das Einlegeteil auf dem Boden der Aussparung des einen Teils des Spritzwerkzeuges aufgelegt werden.

Die Erfindung wird nachfolgend anhand von in der Zeichnung dargestellten Ausführungsbeispielen näher beschrieben. In der Zeichnung zeigen:
- Fig. 1 - 3: Draufsicht, Seitenansicht und Vorderansicht eines Metallstanzgitters;
- Fig. 6: eine Draufsicht auf das Einlegeteil;
- Fig. 7: einen Schnitt nach der Linie VII - VII in Fig. 6;
- Fig. 8: einen Schnitt nach der Linie VIII - VIII in Fig. 6;
- Fig. 9: eine Seitenansicht des Einlegeteils nach Fig. 6;
- Fig. 10 a - d: die beiden Teile des Spritzwerkzeuges sowie das Einlegeteil und das Metallstanzgitter in Sprengansicht;
- Fig. 11: einen Schnitt durch das Spritzwerkzeug mit einem eingelegten vorgefertigten Einlegeteil und Stanzgitter;
- Fig. 12: die Ansicht nach Fig. 11 nach dem Trennen der Verbindungsstege des Stanzgitters und nach dem Einbringen des Kunststoffes;
- Fig. 13: einen Schnitt durch ein auf einer Seite wasserdichtes Fertigteil.

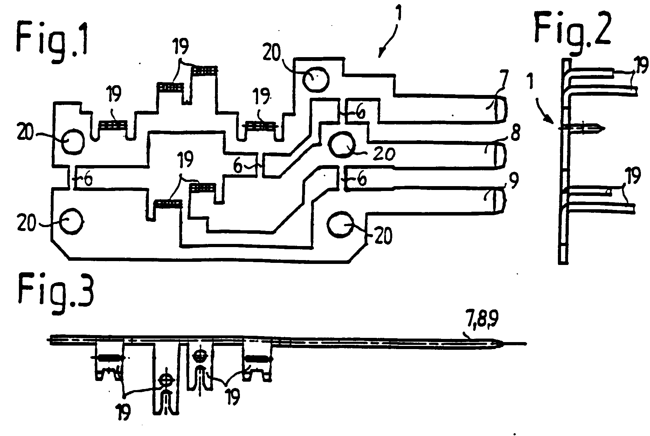

In den Figuren 1 bis 3 ist ein Metallstanzgitter 1 dargestellt. Dieses Metallstanzgitter 1 weist z.B. drei Kontaktbahnen 7, 8, 9 auf, welche durch vier Verbindungsstege 6 zunächst eine einstückige Einheit bilden. Die einzelnen Kontaktbahnen 7, 8, 9 weisen gemäß Fig. 2 und 3 rechtwinklig zur Grundebene aufragende Anschlußfahnen 19 auf. Wie darüber hinaus ersichtlich, befinden sich im Bereich der Kontaktbahnen 7, 8, 9 insgesamt fünf Fixierlöcher 20.

Es ist darauf hinzuweisen, daß es sich bei der Darstellung des Metallstanzgitters um ein spezielles Ausführungsbeispiel handelt. Statt dieses Ausführungsbeispiels kann das Metallstanzgitter eine beliebig andere Form und beliebig anders verlaufende Kontaktbahnen sowie Anschlußfahnen besitzen. Allen diesen Ausführungsformen ist jedoch gemeinsam, daß die einzelnen Kontaktbahnen durch Verbindungsstege 6 zunächst zu einer einstückigen Einheit zusammengefaßt sind und außerdem eine entsprechende Anzahl von Fixierlöchern aufweisen.

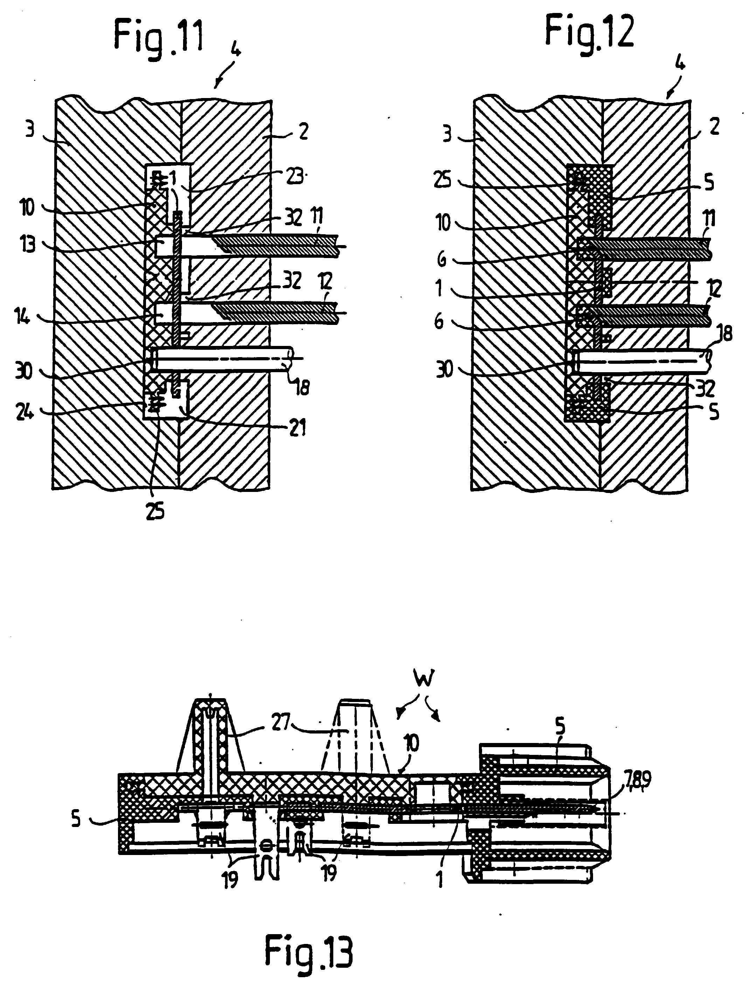

Die Erfindung ermöglicht, ein wasserdichtes Fertigteil gemäß Fig. 13 herzustellen. Dieses auf der Seite W wasserdichte Fertigteil umfaßt z.B. einzelne Kontaktbahnen 7, 8 und 9, welche mit Kunststoff 5 umspritzt sind sowie ein ebenfalls mit dem Kunststoff 5 verbundenes Einlegeteil 10. Dieses Einlegeteil 10 übernimmt die Funktion der Abstützung und Fixierung des Stanzgitters sowie die der Matritze beim Trenn-Biegevorgang und auch die Aufnahme der aufgetrennten Verbindungsstege 6 in geschlossene Taschen 13, 14.

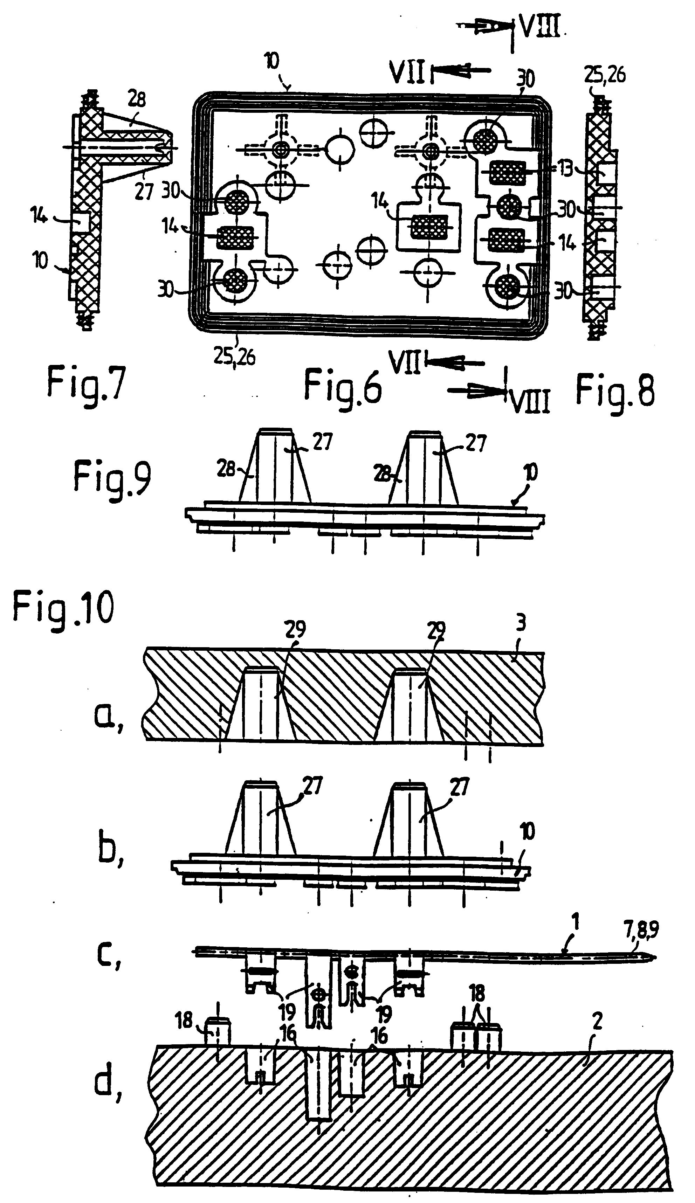

Das Einlegeteil 10 ist in den Figuren 6 - 9 näher dargestellt. Wie ersichtlich, handelt es sich hierbei im wesentlichen um eine Platte, welche auf einer Seite mit einer Anzahl von Taschen 13, 14 und 30 versehen ist. Hierbei dienen die Taschen 30 zur Aufnahme von Fixierstiften 18; die Taschen 13 und 14 dienen zur Einlagerung der Trenn- und Biegemesser 11 und 12.

Auf der anderen Seite des Bodens des Einlegeteils 10 befinden sich Hohlzapfen 27, an welchen außenseitig Verstärkungsrippen 28 angeformt sind. Die Platte des Einlegeteils 10 weist außenseitig einen umlaufenden Bund 26 auf, welcher mit Profilierungen 25 versehen ist.

Fig. 10 a - 10 c zeigen das Einlegeteil 10, das Metallstanzgitter 1, das Unterteil 2 und das Oberteil 3 des Spritzwerkzeuges 4 in Sprengansicht: Hierbei stellt Fig. 10 a das Oberteil 3 des Spritzwerkzeuges 4 dar, welches mit Ausnehmungen 29 zur Aufnahme der Hohlzapfen 27 und der Verstärkungen 28 des in Fig. 10 b dargestellten Einlegeteils 10 ausgestattet sind. Fig. 10 c zeigt das Metallstanzgitter 1 in Seitenansicht mit den Kontaktfahnen 19. Fig. 10 d schließlich zeigt den unteren Teil 2 des Spritzwerkzeuges 4 mit Aussparungen 16 sowie den Fixierzapfen 18.

Das vorgenannte, in den Figuren 6 - 9 dargestellte, aus Kunststoff bestehende Einlegeteil 10 wird nach Fig. 11 auf den Boden 24 des Teils 3 des Spritzwerkzeugs 4 aufgelegt. Durch die Stege 32 des oberen Teils 2 des Spritzwerkzeuges 4 sowie durch die Fixierstifte 18, welche durch die Löcher 20 des Metallstanzgitters in die entsprechenden Taschen 30 des Einlegeteils 10 eingreifen, ist eine einwandfreie Fixierung des Einlegeteils 10 und des Metallstanzgitters 1 gewährleistet. Auch die umgekehrte Einlegefolge ist möglich mit Unterteil 3 und Oberteil 2.

Nunmehr können gemäß Fig. 12 die Trenn- und Biegemesser 11, 12 den Trennvorgang der Verbindungsstege 6 durchführen und diese entsprechend mit ihrer Stirnseite umbiegen. Danach erfolgt analog dem Verfahrensschritt gemäß Fig. 5 das Umspritzen mit Kunststoff 5, wobei dieser die Profilierung 25 des Bundes 24 des Einlegeteils 10 umschließt und somit eine einwandfreie, wasserdichte Ausführungsform des in Fig. 13 dargestellten Fertigteils gewährleistet. Auch die umgekehrte Einlegefolge mit Unterteil 3 und Oberteil 2 ist möglich.

Nach Fertigstellung werden die Trenn- und Biegemesser 11 und 12 sowie die Fixierstifte 18 in ihre Ausgangsposition zurückbewegt, wonach nach Öffnen der beiden Teile 2 und 3 des Spritzwerkzeuges 4 das so hergestellte Fertigteil entnommen werden kann.

Insgesamt gewährleistet das erfindungsgemäße Verfahren eine rasche und kostensparende Möglichkeit des Umspritzens elektrischer Kontaktbahnen, wobei auch ein wasserdichtes Fertigteil gemäß Fig. 13 hergestellt werden kann. Durch das erfindungsgemäße Verfahren wird vorteilhafterweise ein nachträgliches Trennen der Verbindungsstege in einem separaten Arbeitsgang nicht mehr notwendig.

Die Teile 2 und 3 des Spritzwerkzeuges 4 sind entsprechend der Form des Einlegeteils 10 und des Metallstanzgitters 1 zu gestalten, um zu gewährleisten, daß die Trenn- und Biegemesser 11 und 12 sowie die Fixierstifte 18 in entsprechend gestaltete Aussparungen des Einlegeteils 10 bzw. des unteren Teils 2 des Spritzwerkzeuges 4 eintreten können.

## Patentansprüche

1. Verfahren zum Umspritzen von elektrischen Kontaktbahnen, bei welchem mindestens ein zwischen zwei Teile eines Spritzwerkzeuges eingelegtes Metallstanzgitter durch Trennen von Verbindungsstegen in die einzelnen Kontaktbahnen aufgeteilt und mit Kunststoff umspritzt wird, wobei die Verbindungsstege nach der Fixierung des Metallstanzgitters im Spritzwerkzeug in diesem getrennt und umgebogen und danach die so hergestellten einzelnen Kontaktbahnen (7, 8, 9) mit Kunststoff (5) umspritzt werden.
**dadurch gekennzeichnet,**
daß vor dem Trennen und Umbiegen der Verbindungsstege (6) ein vorgefertigtes Einlegeteil (10) mit einseitig geschlossener Außenkontur in das Spritzwerkzeug (4) eingelegt und zusammen mit den Kontaktbahnen (7, 8, 9) mit Kunststoff (5) umspritzt wird.

2. Verfahren nach Anspruch 1, **dadurch gekennzeichnet,** daß die Verbindungsstege (6) in einem Arbeitsgang einseitig getrennt und umgebogen werden.

3. Verfahren nach Anspruch 2, **dadurch gekennzeichnet,** daß durch Trenn- und Biegemesser (11, 12) die getrennten Verbindungsstege (6) in geschlossene Taschen (13, 14) des vorgespritzten Einlegeteils (10) hineingedrückt werden.

4. Verfahren nach einem der vorhergehenden Ansprüche, **dadurch gekennzeichnet,** daß das Einlegeteil (10) einen zumindest einseitig mit einer Profilierung (25) versehenen, umlaufenden Bund (26) zur Einlagerung in den umspritzten Kunststoff (5) aufweist.

## Claims

1. Method for the overmoulding of electrical contact decks, in which at least one metal punching grid placed between two parts of an injection mould is divided up into the individual contact decks by severing connecting webs and is overmoulded with plastic, in which method, after fixing the metal punching grid in the injection mould, the connecting webs are severed and bent around in the latter and, thereafter, the individual contact decks (7, 8, 9) thus produced are overmoulded with plastic (5), characterized in that, before the severing and bending around of the connecting webs (6), a prefabricated insert part (10) having an outer contour which is closed on one side is placed into the injection mould (4) and is overmoulded with plastic (5) together with the contact decks (7, 8, 9).

2. Method according to Claim 1, characterized in that the connecting webs (6) are severed and bent around at one end in one operation.

3. Method according to Claim 2, characterized in that the severed connecting webs (6) are pressed into closed pockets (13, 14) of the premoulded insert part (10) by means of severing and bending cutters (11, 12).

4. Method according to one of the preceding claims, characterized in that the insert part (10) has a peripheral flange (26), provided at least on one side with a profiling (25), for incorporation in the overmoulded plastic (5).

## Revendications

1. Procédé d'enrobage par injection de pistes électriques de contact, dans lequel au moins un grillage métallique estampé, interposé entre deux parties d'un outil d'injection, est scindé en les pistes individuelles de contact, par séparation de membrures de liaison, puis est enrobé d'une matière plastique par injection, procédé dans lequel, après l'ablocage du grillage métallique estampé dans l'outil d'injection, les membrures de liaison sont séparées et coudées dans ledit outil, après quoi les pistes individuelles de contact (7, 8, 9) ainsi produites sont enrobées d'une matière plastique (5) par injection,
caractérisé par le fait
que, préalablement à la séparation et au rabat des membrures de liaison (6), une pièce intégrée préfabriquée (10) à contour extérieur fermé d'un côté est placée dans l'outil d'injection (4) et est enrobée d'une matière plastique (5), par injection, conjointement aux pistes de contact (7, 8, 9).

2. Procédé selon la revendication 1, caractérisé par le fait que les membrures de liaison (6) sont séparées d'un côté et sont coudées en une intervention.

3. Procédé selon la revendication 2, caractérisé par le fait que les membrures de liaison (6) séparées sont enfoncées, par des couteaux (11, 12) de séparation et de rabat, dans des logements fermés (13, 14) de la pièce intégrée (10) préalablement enrobée par injection.

4. Procédé selon l'une des revendications précédentes, caractérisé par le fait que la pièce intégrée (10) présente une collerette périphérique (26) pourvue d'un profilage (25), au moins d'un côté, en vue de l'encastrement dans la matière plastique (5) injectée périphériquement.
